# EUROPEAN PATENT APPLICATION

(11) **EP 2 648 492 A2**
(43) Date of publication of application: **09.10.2013**
(21) Application number: 13159887.2
(22) Date of filing: 19.03.2013
(51) Int. Cl.: H05K 3/34

(54) **A system provided with a solder joint**

(30) Priority: 04.04.2012 FI 20125384
(71) Applicant: Tellabs Oy, 02630 Espoo (FI)
(72) Inventor: Holma, Antti, 02920 Espoo (FI); Laihonen, Jari-Pekka, 02730 Espoo (FI)
(74) Representative: Väänänen, Janne Kalervo

(57) **Abstract**

A system provided with a solder joint comprises: a circuit board (101) provided with an aperture (102), an electrical component (103) comprising a conductor foot (104) protruding through the aperture, and soldering metal (105) inside the aperture and in contact with the conductor foot. The system further comprises a thermal conductor element (106) comprising a first portion outside the aperture and a second portion inside the aperture and in contact with the soldering metal. The thermal conductor element is capable of conducting heat and thereby it intensifies the heat transfer into the aperture during pre-heating which precedes the process phase when the molten soldering metal is enabled to be absorbed into the aperture. Thus the reliability of the solder joint is improved, i.e. a risk of a faulty "cold" solder is decreased.

## Description

### Field of the invention

The invention relates generally to solder joints. More particularly, the invention relates to a system provided with a solder joint. Furthermore, the invention relates to method for making a solder joint.

### Background

Many electronic devices comprise a circuit board and electrical components having conductor feet protruding through apertures of the circuit board. The conductor feet of the electrical components are connected to electrical conductors of the circuit board by soldering so that the apertures are at least partially filled with soldering metal. The soldering can be carried out, for example, as a wave soldering where a wave of molten solder metal is arranged to sweep the side of the circuit board opposite to the side where of the electrical components are located.

In order to provide a reliable solder joint between a conductor foot of an electrical component and one or more electrical conductors of the circuit board, the temperatures of both the conductor foot and the electrical conductors of the circuit board have to be high enough when the soldering metal is let to be absorbed into the respective aperture of the circuit board. Otherwise there is a considerable risk of a forming a faulty "cold" solder joint. An inherent challenge related to the soldering is constituted by the thermal conductivity of the electrical conductors of the circuit board because temperature gradients in the electrical conductors tend to flatten, and this phenomenon lowers the temperature of contact portions of the electrical conductors which are in contact with the soldering metal. Typically, this problem is pursued to be solved by arranging narrow isthmuses between the above-mentioned contact portions of the electrical conductors and other portions of the electrical conductors so as to decrease the heat conduction from the contact portions of the electrical conductors. However, these isthmuses must not be too narrow and/or too long because narrowing and/or lengthening the isthmuses increases electrical resistances between the contact portions and the other portions of the electrical conductors. Thus, there is an inherent trade-off between the thermal conductivity and the electrical resistances, and thereby there is a need for other technical solutions for providing reliable solder joints.

### Summary

The following presents a simplified summary in order to provide a basic understanding of some aspects of various invention embodiments. The summary is not an extensive overview of the invention. It is neither intended to identify key or critical elements of the invention nor to delineate the scope of the invention. The following summary merely presents some concepts of the invention in a simplified form as a prelude to a more detailed description of exemplifying embodiments of the invention.

In accordance with the first aspect of the invention, there are provided new methods for making a solder joint.

Methods according to first exemplifying embodiments of the invention comprise:
- installing a conductor foot of an electrical component through an aperture of a circuit board,
- installing a thermal conductor element so that a first portion of the thermal conductor element is left outside the aperture and a second portion of the thermal conductor element gets inside the aperture, at least a part of the first portion of the thermal conductor element being separate with respect to the conductor foot of the electrical component,
- directing heat to the thermal conductor element so as to conduct heat to the aperture, and subsequently
- letting molten soldering metal to be absorbed into the aperture.

The installing of the conductor foot and the installing of the thermal conductor element are not necessarily carried out separately and/or in the order they are mentioned above, i.e. in some exemplifying and non-limiting embodiments of the invention, these actions can be carried out in a different order or simultaneously. The thermal conductor element intensifies the heat transfer into the aperture during a pre-heating phase which precedes the process phase when the molten soldering metal is enabled to be absorbed into the aperture. Therefore, the reliability of the solder joint is improved, i.e. the risk of a faulty "cold" solder is decreased.

Methods according to second exemplifying embodiments of the invention comprise:
- installing a conductor foot of an electrical component in an aperture of a circuit board and bending the conductor foot so that a part of the conductor foot gets at least doubly in the aperture,
- directing heat to the conductor foot so as to conduct heat to the aperture, and subsequently
- letting molten soldering metal to be absorbed into the aperture.

The above-mentioned installing and the bending are not necessarily carried out in the order they are mentioned above. For example, in some cases it may be more advantageous to bend the conductor foot before it is installed in the aperture.

In accordance with the second aspect of the invention, there is provided a new system provided with a solder joint. A system according to the invention comprises:
- a circuit board provided with an aperture,
- an electrical component comprising a conductor foot protruding through the aperture,
- a thermal conductor element being a metal wire and comprising a first portion outside the aperture and a second portion inside the aperture, the thermal conductor element being capable of conducting heat to/from the aperture and at least a part of the first portion of the thermal conductor element being separate with respect to the conductor foot of the electrical component, and
- soldering metal inside the aperture and in contact with the conductor foot and with the second portion of the thermal conductor element.

The system according to the invention can be a part of an electronic device that can be, for example but not necessarily, internet protocol "IP" router, an Ethernet switch, and/or a multiprotocol label switching "MPLS" switch.

A number of non-limiting exemplifying embodiments of the invention are described in accompanied dependent claims.

Various non-limiting exemplifying embodiments of the invention both as to constructions and to methods of operation, together with additional objects and advantages thereof, will be best understood from the following description of specific exemplifying embodiments when read in connection with the accompanying drawings.

The verbs "to comprise" and "to include" are used in this document as open limitations that neither exclude nor require the existence of unrecited features. The features recited in depending claims are mutually freely combinable unless otherwise explicitly stated.

### Brief description of the figures

The exemplifying embodiments of the invention and their advantages are explained in greater detail below in the sense of examples and with reference to the accompanying drawings, in which:
figure 1 shows a schematic section view of a part of a system according to an exemplifying embodiment of the invention,
figure 2 shows a schematic section view of a part of a system according to an exemplifying embodiment of the invention under a manufacturing process,
figure 3 shows a schematic section view of a part of a system according to an exemplifying embodiment of the invention,
figure 4 shows a schematic section view of a part of a system according to an exemplifying embodiment of the invention,
figure 5a shows a schematic section view of a part of a system according to an exemplifying embodiment of the invention,
figure 5b shows a schematic section view of a part of a system according to an exemplifying embodiment of the invention,
figure 6 shows a flowchart of a method according to an exemplifying embodiment of the invention for making a solder joint, and
figure 7 shows a flowchart of a method according to an exemplifying embodiment of the invention for making a solder joint.

### Description of the exemplifying embodiments

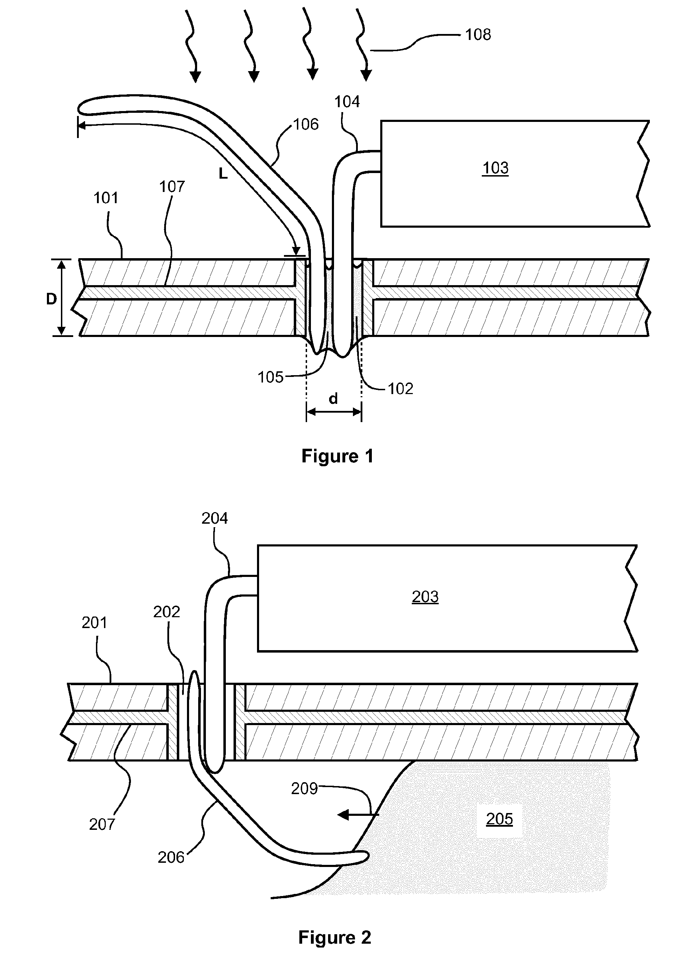

Figure 1 shows a schematic section view of a part of a system according to an embodiment of the invention. The system comprises a circuit board 101 provided with an aperture 102. The circuit board comprises an electrical conductor 107 which covers the walls of the aperture as illustrated in the section view shown by figure 1. The thickness of the electrical conductor 107 with respect to the thickness D of the circuit board 101 and the diameter d of the aperture is exaggerated for the sake of illustrative purposes. Typically a circuit board comprises many, e.g. seven, layers each of which having electrical conductors and there can be electrical conductors also on the surfaces of the circuit board. For the sake of clarity, figure 1 shows however a simpler case. The system comprises an electrical component 103 which comprises a conductor foot 104 protruding through the aperture 102. The electrical component can be e.g. an overvoltage protector, an inductor coil, a capacitor, a semiconductor component such as a transistor, an integrated circuit, or some other electrical component. Typically the electrical component 103 comprises more than one conductor foot but only one of the conductor feet is shown in figure 1. The system comprises soldering metal 105 inside the aperture and in contact with the conductor foot 104. Typically the soldering metal is alloy which comprises mainly tin and other metals as smaller shares. The composition of the soldering metal can be for example Sn 96.5 % -Ag 3 % -Cu 0.5 % or Sn 99.3 %-Cu 0.7 %.

The system further comprises a thermal conductor element 106 comprising a first portion outside the aperture and a second portion inside the aperture. The second portion is in contact with the soldering metal 105. The thermal conductor element 106 is a piece of a metal wire and it is a separate element with respect to the conductor foot 104 of the electrical component. The material of the thermal conductor element 106 can comprise, for example, copper as a main component. The thermal conductor element 106 is capable of conducting heat to the aperture during a pre-heating phase that precedes the phase when the molten soldering metal is enabled to be absorbed into the aperture. This exemplifying embodiment of the invention, in which the first portion of the thermal conductor element 106 is located on the same side of the circuit board as the electrical component 103, is suitable for cases where the pre-heating is carried out by directing heat radiation or hot gas from above as illustrated by wavy arrows 108 shown in figure 1. The thermal conductor element captures heat energy and conducts the captured heat energy into the aperture. Therefore, the reliability of the solder joint is improved, i.e. the risk of a faulty "cold" solder is decreased. In order to achieve a sufficient effect, the length L of the first portion of the thermal conductor element is advantageously at least three times the thickness D of the circuit board. The length L is illustrated in figure 1.

Figure 2 shows a schematic section view of a part of a system according to an exemplifying embodiment of the invention under a manufacturing process. The system comprises a circuit board 201 provided with an aperture 202 and with an electrical conductor 207. The system comprises an electrical component 203 comprising a conductor foot 204 protruding through the aperture. The system further comprises a thermal conductor element 206 comprising a first portion outside the aperture and a second portion inside the aperture. In the manufacturing process phase illustrated in figure 2, there is not yet any soldering metal inside the aperture 202 but a wave of soldering metal 205 is approaching the aperture. The wave is moving towards the aperture as illustrated by an arrow 209 in figure 2.

In the exemplifying embodiment shown in figure 2, the first portion of the thermal conductor element is located on the opposite side of the circuit board 201 with respect the electrical component 203. As illustrated in figure 2, the thermal conductor element 206 is capable of absorbing heat from the wave of the soldering metal 205.

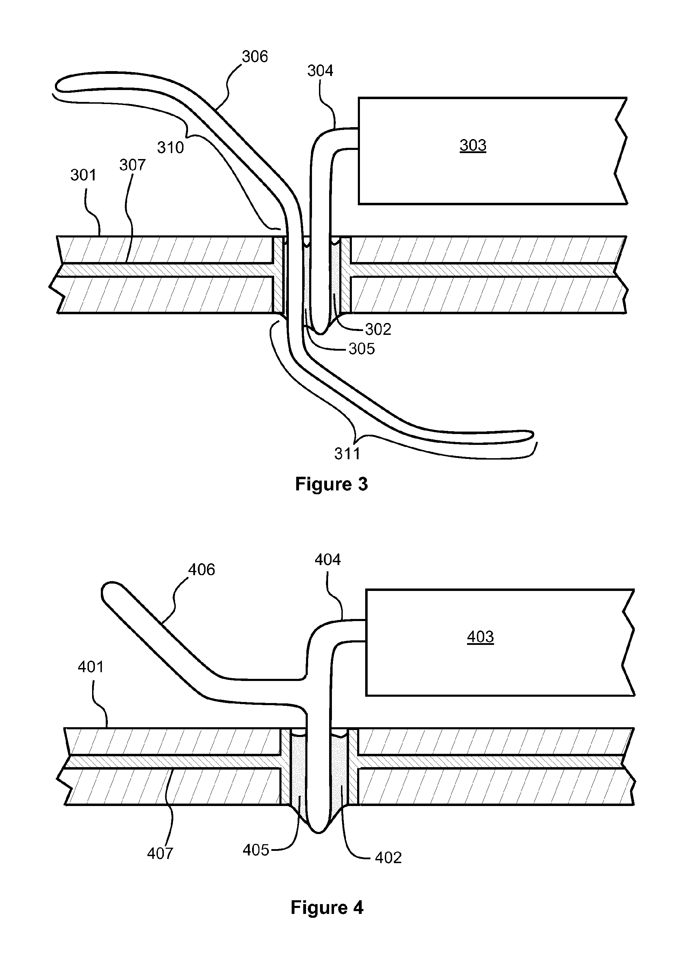

Figure 3 shows a schematic section view of a part of a system according to an exemplifying embodiment of the invention. The system comprises a circuit board 301 provided with an aperture 302 and with an electrical conductor 307. The system comprises an electrical component 303 comprising a conductor foot 304 protruding through the aperture. The system further comprises a thermal conductor element 306 comprising a first portion 310 outside the aperture and a second portion inside the aperture. The thermal conductor element 306 further comprises a third portion 311 outside the aperture and located on an opposite side of the circuit board with respect to the first portion of the thermal conductor element. The system further comprises soldering metal 305 inside the aperture and in contact with the conductor foot 304 of the electrical component 303 and with the second portion of the thermal conductor element.

Figure 4 shows a schematic section view of a part of a system according to an exemplifying embodiment of the invention. The system comprises a circuit board 401 provided with an aperture 402 and with an electrical conductor 407. The system comprises an electrical component 403 comprising a conductor foot 404 protruding through the aperture. The system further comprises soldering metal 405 inside the aperture and in contact with the conductor foot 404 of the electrical component 403. The system further comprises a thermal conductor element 406 comprising a first portion outside the aperture and a second portion inside the aperture. In this exemplifying embodiment of the invention, the first portion of the thermal conductor element comprises a metal wire branching from the conductor foot 404 and the part of the conductor foot which is located in the aperture constitutes the second portion of the thermal conductor element.

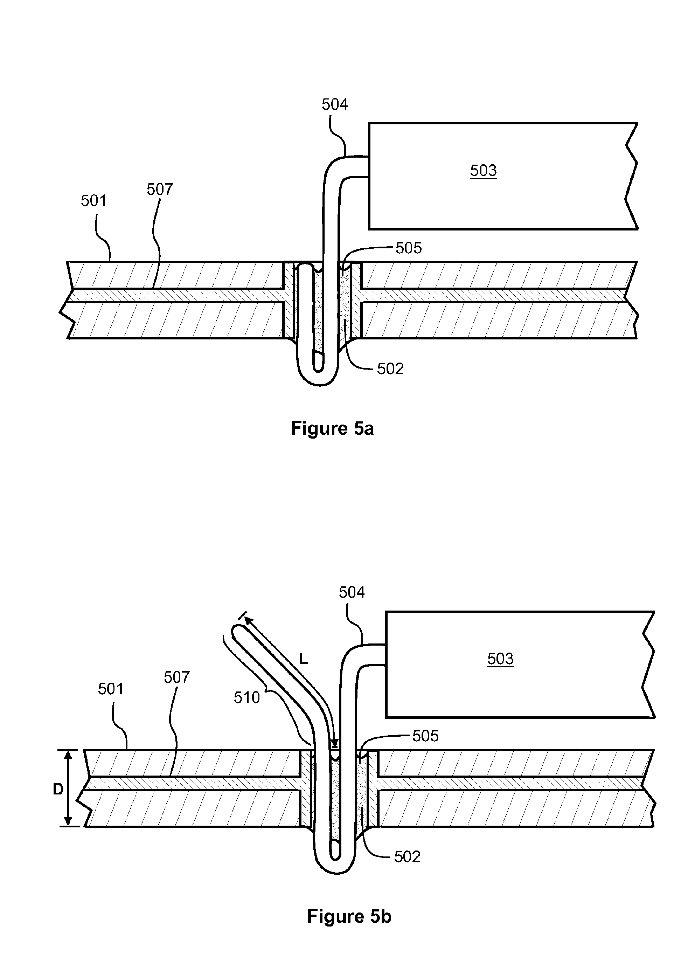

Figure 5a shows a schematic section view of a part of a system according to an exemplifying embodiment of the invention. The system comprises a circuit board 501 provided with an aperture 502 and with an electrical conductor 507. The system comprises an electrical component 503 on a first side of the circuit board. The electrical component comprises a conductor foot 504 that is bent so that a part of the conductor foot is doubly in the aperture as illustrated in figure 5a. Depending on the diameter of the aperture and on the material and the thickness of the conductor foot, it may be in some cases possible to bend the conductor foot so many times that a part of the conductor foot can be triply or more-fold in the aperture.

Figure 5b shows a schematic section view of a part of a system according to an exemplifying embodiment of the invention. The system shown in figure 5b corresponds otherwise to the system shown in figure 5a, but the conductor foot 504 comprises a first portion 510 that is outside the aperture on the first side of the circuit board 501.

In a system according to an exemplifying embodiment of the invention, the length L of the first portion 510 of the conductor foot is at least 1.5 times the thickness D of the circuit board. The length L and the thickness D are illustrated in figure 5b.

Each of the above-presented exemplifying systems can be a part of an electronic device which can be, for example but not necessarily, an internet protocol "IP" router, an Ethernet switch, and/or a multiprotocol label switching "MPLS" switch.

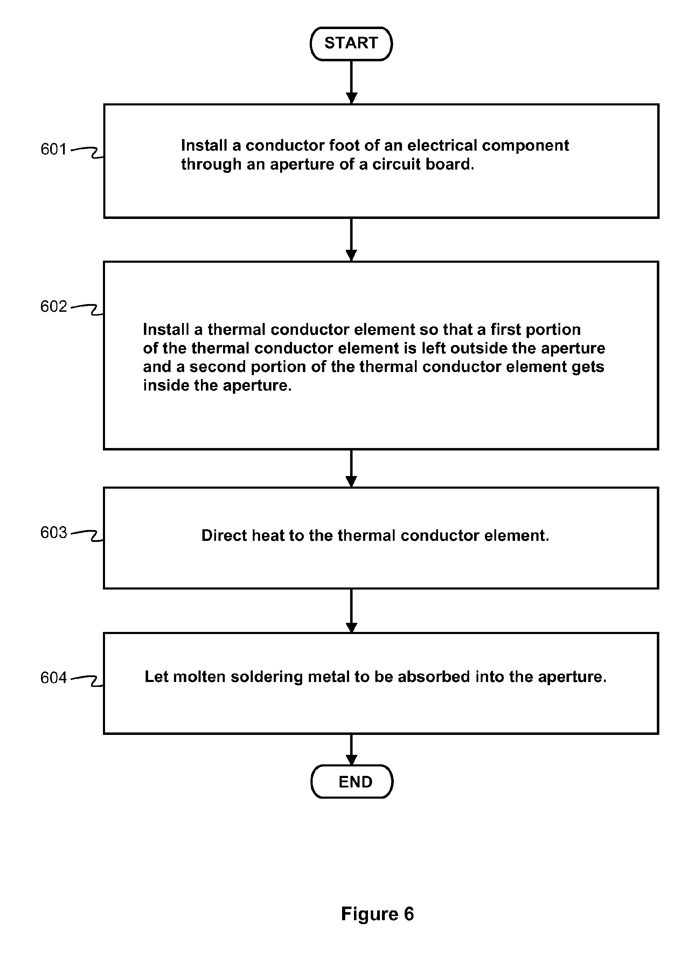

Figure 6 shows a flowchart of a method according to an exemplifying embodiment of the invention for making a solder joint. The method comprises the following actions:
- action 601: installing a conductor foot of an electrical component through an aperture of a circuit board,
- action 602: installing a thermal conductor element so that a first portion of the thermal conductor element is left outside the aperture and a second portion of the thermal conductor element gets inside the aperture, at least a part of the first portion of the thermal conductor element being separate with respect to the conductor foot of the electrical component,
- action 603: directing heat to the thermal conductor element so as to conduct heat to the aperture, and
- action 604: letting molten soldering metal to be absorbed into the aperture.

The action 601 and the action 602 are not necessarily carried out separately and/or in the order they are mentioned above. For example, when making a system according to figure 4, these actions 601 and 602 are inherently carried out simultaneously.

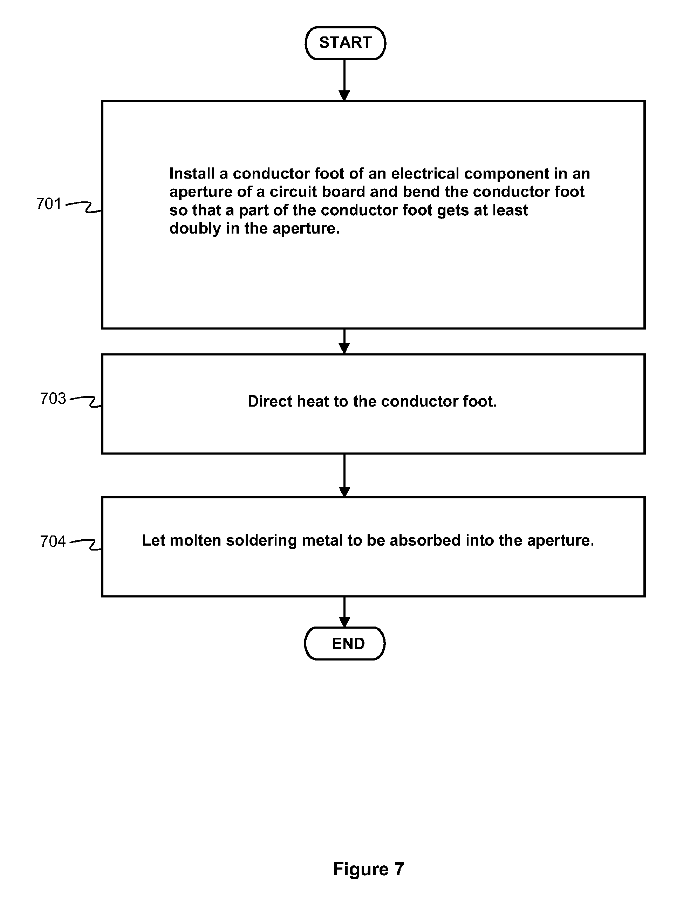

Figure 7 shows a flowchart of a method according to an exemplifying embodiment of the invention for making a solder joint. The method comprises the following actions:
- action 701: installing a conductor foot of an electrical component in an aperture of a circuit board and bending the conductor foot so that a part of the conductor foot gets at least doubly in the aperture,
- action 702: directing heat to the conductor foot so as to conduct heat to the aperture, and
- action 703: letting molten soldering metal to be absorbed into the aperture.

The above-mentioned installing and the bending are not necessarily carried out in the order they are mentioned above. For example, in some cases it may be more advantageous to bend the conductor foot before it is installed in the aperture. The diameter of the aperture, the diameter of the conductor foot, the length of the conductor foot, and the flexibility of the conductor foot are factors which, inter alia, define the advantageous temporal order of the installing and the bending.

The specific examples provided in the description given above should not be construed as limiting the applicability and/or the interpretation of the appended claims.

## Claims

1. A system provided with a solder joint, the system comprising:
- a circuit board (101, 301, 401) provided with an aperture (102, 302, 402),
- an electrical component (103, 303, 403) comprising a conductor foot (104, 304, 404) protruding through the aperture, and
- soldering metal (105, 305, 405) inside the aperture and in contact with the conductor foot
**characterized in that** the system further comprises a thermal conductor element (106, 306, 406) being a metal wire and comprising a first portion outside the aperture and a second portion inside the aperture and in contact with the soldering metal, the thermal conductor element being capable of conducting heat to/from the aperture and at least a part of the first portion of the thermal conductor element being separate with respect to the conductor foot of the electrical component.

2. A system according to claim 1, wherein the thermal conductor element (106, 206, 306) is separate with respect to the conductor foot of the electrical component.

3. A system according to claim 1 or 2, wherein the first portion of the thermal conductor element (106, 406) is located on a same side of the circuit board as the electrical component.

4. A system according to claim 1 or 2, wherein the first portion of the thermal conductor element (206) is located on an opposite side of the circuit board with respect the electrical component.

5. A system according to claim 1 or 2, wherein the thermal conductor element (306) further comprises a third portion outside the aperture and located on an opposite side of the circuit board with respect to the first portion of the thermal conductor element.

6. A system according to claim 1, wherein the first portion of the thermal conductor element (406) is branching from the conductor foot and wherein a part of the conductor foot located in the aperture constitutes the second portion of the thermal conductor element.

7. A system according to any of claims 1-6, wherein the length (L) of the first portion of the thermal conductor element is at least three times the thickness (D) of the circuit board.

8. A system according to any of claims 1-7, wherein the soldering metal comprises tin.

9. A system according to any of claims 1-8, wherein the thermal conductor element comprises copper.

10. An electronic device comprising a system according to any of claims 1-9.

11. An electronic device according to claim 10, wherein the electronic device is at least one of the following: an internet protocol "IP" router, an Ethernet switch, a multiprotocol label switching "MPLS" switch.

12. A method for making a solder joint, the method comprising:
- installing (601) a conductor foot of an electrical component through an aperture of a circuit board, and
- letting (604) molten soldering metal to be absorbed into the aperture,
**characterized in that** the method comprises, prior to the letting the molten soldering metal to be absorbed into the aperture:
- installing (602) a thermal conductor element so that a first portion of the thermal conductor element is left outside the aperture and a second portion of the thermal conductor element gets inside the aperture, at least a part of the first portion of the thermal conductor element being separate with respect to the conductor foot of the electrical component, and
- directing (603) heat to the thermal conductor element so as to conduct heat to the aperture.

13. A method for making a solder joint, the method comprising:
- installing (701) a conductor foot of an electrical component in an aperture of a circuit board and bending the conductor foot so that a part of the conductor foot gets at least doubly in the aperture, and
- letting (703) molten soldering metal to be absorbed into the aperture,
**characterized in that** the method comprises, prior to the letting the molten soldering metal to be absorbed into the aperture:
- directing (702) heat to the conductor foot so as to conduct heat to the aperture.
